# EUROPÄISCHE PATENTANMELDUNG

(11) **EP 4 061 101 A1**
(43) Veröffentlichungstag der Anmeldung: **21.09.2022**
(21) Anmeldenummer: 22167179.5
(22) Anmeldetag: 07.08.2015
(51) Int. Cl.: H05K 3/00, B23K 26/0622, B23K 26/382, C03C 15/00, C03C 23/00, H01L 21/48, H01L 23/498, B23K 101/40, B23K 103/00, H01L 23/15

(54) **VERFAHREN ZUM EINBRINGEN MINDESTENS EINER AUSNEHMUNG ODER EINER DURCHBRECHUNG IN EIN PLATTENFÖRMIGES WERKSTÜCK**

(30) Priorität: 16.09.2014 DE 102014113339; 07.11.2014 DE 102014116291
(62) Teilanmeldung aus: 15762474.3
(71) Anmelder: LPKF Laser & Electronics AG, 30827 Garbsen (DE)
(72) Erfinder: OSTHOLT, Roman, 30855 Langenhagen (DE); AMBROSIUS, Norbert, 30827 Garbsen (DE)
(74) Vertreter: Scheffler, Jörg

(57) **Zusammenfassung**

Die Erfindung betrifft ein Verfahren zum Einbringen mindestens einer Ausnehmung (4), insbesondere als eine Durchbrechung, in ein plattenförmiges Werkstück (1) mit einer Dicke kleiner als 3 Millimeter. Hierzu wird eine Laserstrahlung (2) auf die Oberfläche des Werkstückes (1) gerichtet. Die Einwirkungsdauer der Laserstrahlung (2) wird äußerst kurz gewählt, sodass lediglich eine Modifikation des Werkstückes (1) konzentrisch um eine Strahlachse des Laserstrahles eintritt. Ein derart modifizierter Bereich mit Fehlstellen (3) führt zu einer Kette von Bläschen. In einem nachfolgenden Verfahrensschritt kommt es aufgrund der Einwirkung eines ätzenden Mediums durch sukzessives Aufätzen zu einem anisotropen Materialabtrag in denjenigen, durch die Fehlstellen (3) gebildeten Bereichen des Werkstückes (1), die zuvor eine Modifikation durch die Laserstrahlung (2) erfahren haben. Entlang der zylindrischen Einwirkungszone entsteht dadurch eine Ausnehmung (4) als Durchbrechung in dem Werkstück (1).

## Beschreibung

Die Erfindung betrifft ein Verfahren zum Einbringen mindestens einer Ausnehmung oder Durchbrechung in ein plattenförmiges Werkstück mit einer Dicke kleiner als 3 Millimeter. Ein Mikrochip als Prozessorkern hat typischerweise auf seiner Unterseite auf relativ kleiner Fläche verteilt mehrere Hundert Kontaktpunkte in engem Abstand zueinander. Wegen dieses engen Abstandes können diese Kontaktpunkte nicht direkt auf eine Schaltungsplatte, das sogenannte Motherboard, aufgebracht werden. Es wird deshalb ein sogenannter Interposer aus isolierendem Material als Verbindungselement eingesetzt, mit welchem die Kontaktierungsbasis verbreitert werden kann. So eine Isolier- und Umverdrahtungsschicht besteht beispielsweise aus Glas, aus glasfaserverstärktem Epoxydharz oder Silizium und muss mit einer Vielzahl von Durchbrechungen versehen sein.

Glas ist als Interposermaterial besonders vorteilhaft, da es kostengünstiger als Silizium ist und hinsichtlich seiner Temperaturausdehnung an die der aktiven Komponenten, beispielsweise Mikroprozessoren, angepasst werden kann. Als Herausforderung gestaltet sich die Verarbeitung des Glases zu gebrauchsfähigen Interposern. Insbesondere die wirtschaftliche Einbringung der Vielzahl an Durchbrechungen in das Glaswerkstück zur Durchkontaktierung ist im Stand der Technik noch nicht wirtschaftlich gelöst.

So ist aus der DE 10 2010 025 966 B4 ein Verfahren bekannt, bei dem in einem ersten Schritt auf das Glaswerkstück fokussierte Laserimpulse gerichtet werden, deren Strahlungsintensität so stark ist, dass es zu lokaler, athermischer Zerstörung entlang eines Kanals im Glas kommt. In einem zweiten Verfahrensschritt werden die Kanäle zu Löchern aufgeweitet, indem gegenüberstehenden Elektroden Hochspannungsenergie zugeführt wird, was zu dielektrischen Durchbrüchen durch das Glaswerkstück entlang der Kanäle führt. Diese Durchbrüche erweitern sich durch elektrothermische Aufheizung und Verdampfung von Lochmaterial, bis der Vorgang bei Erreichen des gewünschten Lochdurchmessers durch Abschalten der Energiezufuhr gestoppt wird. Alternativ oder zusätzlich können die Kanäle auch durch reaktive Gase aufgeweitet werden, die mittels Düsen auf die Lochungsstellen gerichtet werden. Die Durchbruchsstellen können auch durch zugeführtes Ätzgas aufgeweitet werden. Als nachteilig erweist sich der vergleichsweise aufwendige Vorgang, der dadurch entsteht, dass zuerst durch die athermische Zerstörung das Werkstück durchbrochen und im nächsten Schritt der Durchmesser der Kanäle zu Löchern aufgeweitet werden muss.

Ein Verfahren zur Bearbeitung von Glas durch die Erzeugung von Filamenten ist aus der US 2013/126573 A1 bekannt. Der Begriff Filament bezeichnet eine Strahlausbreitung ohne Beugung innerhalb eines Mediums aufgrund von Selbstfokussierung. Bei geeigneter Wahl von Pulsenergie und Pulsdauer, vor allem bei der bevorzugten Verwendung von Pulsfolgen mit einer Wiederholrate im Megahertz-Bereich und Pulsdauern kleiner als 10 Pikosekunden, entstehen Filamente aufgrund von gegenläufigen Effekten, nämlich der Selbstfokussierung aufgrund des Kerr-Effektes und der Defokussierung durch Beugung aufgrund des kleinen Strahldurchmessers. Durch ein Gleichgewicht beider Effekte kann der Laserstrahl durch das für die Wellenlänge transparente Material propagieren, wobei sein Durchmesser zumindest im Wesentlichen konstant bleibt. Die Materialbearbeitung wird beim beschriebenen Verfahren unterhalb der Schwelle für optischen Durchbruch ausgeführt. Daher ist entgegen konventioneller Materialbearbeitung mit Pikosekunden- und Femtosekundenpulsen eine schwache Fokussierung des Laserstrahles nötig.

Der Erfindung liegt die Aufgabe zugrunde, dass nasschemisches oder Trockenätzen an Fehlstellen im Material anisotrop angreifen kann. Dadurch können in einem ersten Schritt erzeugte Fehlstellen sukzessive vergrößert werden und damit eine Ausnehmung oder Durchbrechung erzeugt werden. Dieses Verfahren erlaubt die Erzeugung einer Vielzahl von Ausnehmungen oder Durchbrechungen mit wesentlich verringertem Zeitaufwand. Die Aufgabe wird erfindungsgemäß mit einem Verfahren gemäß den Merkmalen des Anspruches 1 gelöst. Die weitere Ausgestaltung der Erfindung ist den Unteransprüchen zu entnehmen.

Erfindungsgemäß ist also ein Verfahren vorgesehen, bei dem beispielsweise ein Laserstrahl derart kurzzeitig auf das Glaswerkstück gerichtet wird, dass lediglich eine Kette von Modifikationen im Material des Werkstückes, bevorzugt entlang einer Strahlachse des Laserstrahles erfolgt, ohne dass es zu einer Zerstörung des Werkstückes kommt, und bei dem im nächsten Schritt ein anisotroper Materialabtrag nur in denjenigen Bereichen des Werkstückes durchgeführt wird, die zuvor eine Fehlstelle mittels des Laserstrahles erfahren haben, und so eine Ausnehmung oder Durchbrechung in das Glaswerkstück eingebracht wird. Typischerweise wird durch die Laserstrahlung eine lineare Kette von Bläschen im Werkstück erzeugt. Die einzelnen Bläschen werden durch den Angriff des Ätzmediums vergrößert.

Dabei soll im Sinne der vorliegenden Erfindung unter dem Begriff einer Durchbrechung eines Werkstückes eine durch die gesamte Dicke des Werkstückes verlaufende Öffnung wie beispielsweise eine Durchgangsbohrung verstanden werden, während eine nicht durch die gesamte Dicke des Werkstückes verlaufende Öffnung, wie beispielsweise ein Sackloch, als Ausnehmung bezeichnet wird.

Unter Fehlstellen sind im Folgenden lokal begrenzte Bläschen und/oder chemische Modifikation zu verstehen.

Die Ausnehmung oder Durchbrechung wird dabei infolge eines sukzessiven Aufätzens von einer Mehrzahl von aneinander gereihten Fehlstellen gebildet, indem durch den Ätzvorgang sukzessive die zuvor erzeugten Fehlstellen, die durch die Ätzwirkung zu einem Hohlraum in dem Werkstück erweitert werden, verbunden werden. Hierdurch gelangt die Ätzflüssigkeit schnell von Fehlstelle zu Fehlstelle. Dabei ist der Einfluss der Schwerkraft nicht entscheidend. Vielmehr gelingt der Ätzfortschritt in vergleichbarer Weise von oben nach unten wie umgekehrt, sodass insbesondere der Ätzvorgang an beiden Außenseiten zugleich beginnen kann.

Durch die Fehlstellen, die als Modifikationen innerhalb des Werkstückes erzeugt werden, folgt der Ätzvorgang der Linie, auf der die Fehlstellen angeordnet sind. Die Linie kann eine Gerade sein oder einer nahezu beliebigen Kontur folgen, die durch den Ätzvorgang präzise eingehalten wird. Somit ist es erstmals auch möglich, eine nahezu beliebige Schnittkontur zu erzeugen.

Obwohl es durch die längere Einwirkungsdauer im Bereich der den Außenseiten zugewandten Fehlstellen im Vergleich zu weiter innen in dem Werkstück liegenden Fehlstellen zu einer größeren Erweiterung kommt, ist dennoch eine insgesamt geringe kegelförmige Aufweitung zu beobachten. Die so erzeugte Kontur der Ausnehmung oder Durchbrechung ist nach dem Abschluss des Ätzvorganges durch eine Abfolge von Querschnittserweiterungen und Einschnürungen gekennzeichnet, wobei die Querschnittserweiterungen und Einschnürungen weder eine übereinstimmende Querschnittsfläche noch einen übereinstimmenden Abstand zu benachbarten Querschnittserweiterungen und Einschnürungen aufweisen müssen.

Da eine so beschriebene Struktur der äußeren Gestalt eines Regenwurmes (lat. lumbricus terrestris) entspricht, würde der Fachmann diese als Regenwurmstruktur beschreiben.

Unter den Begriff der Regenwurmstruktur fallen daher regelmäßige und unregelmäßige Querschnittserweiterungen und Einschnürungen, deren Übergang stetig oder unstetig sein kann. Eine Querschnittserweiterung oder Einschnürung kann dabei in einer Querschnittsebene zur Hauptachse oder geneigt hierzu verlaufen. Benachbarte Querschnittserweiterungen oder Einschnürungen können weiterhin auch Mittelpunkte aufweisen, die nicht auf derselben Geraden liegen, sodass die Querschnittserweiterungen oder Einschnürungen versetzt zueinander angeordnet sind. Auch die Höhe benachbarter Querschnittserweiterungen kann übereinstimmend sein oder voneinander abweichen. Ferner kann selbstverständlich auch die Hauptachse der Ausnehmung oder Durchbrechung abweichend von einer Flächennormalen zu der Oberfläche des Werkstückes geneigt verlaufen, während die Querschnittserweiterungen und Einschnürungen in einer zu der Oberfläche des Werkstückes parallelen Ebene ausgerichtet sind.

Die Regenwurmstruktur ist dabei vergleichbar mit einem anderen, aus dem Stand der Technik bekannten Verfahren, welches als reaktives lonentiefenätzen (deep reactive ion etching, DRIE) bezeichnet wird. Dabei handelt es sich um einen anisotropen Trockenätzprozess, der ebenfalls für die Herstellung von Mikrostrukturen in Silicium beispielsweise für die Herstellung von Silizium-Durchkontaktierungen eingesetzt wird. Bei der Durchführung des erfindungsgemäßen Verfahrens müssen daher nachfolgende Prozesse nicht oder nur geringfügig angepasst werden.

Die Ausnehmung oder Durchbrechung wird dabei infolge eines sukzessiven Aufätzens von einer Mehrzahl von aneinander gereihten Fehlstellen gebildet, indem durch den Ätzvorgang sukzessive die zuvor erzeugten Fehlstellen, die durch die Ätzwirkung zu einem Hohlraum in dem Werkstück erweitert werden, verbunden werden. Hierdurch gelangt die Ätzflüssigkeit schnell von Fehlstelle zu Fehlstelle. Dabei ist der Einfluss der Schwerkraft nicht entscheidend. Vielmehr gelingt der Ätzfortschritt in vergleichbarer Weise von oben nach unten wie umgekehrt, sodass insbesondere der Ätzvorgang an beiden Außenseiten zugleich beginnen kann.

Durch die Fehlstellen, die als Modifikationen innerhalb des Werkstückes erzeugt werden, folgt der Ätzvorgang der Linie, auf der die Fehlstellen angeordnet sind. Die Linie kann eine Gerade sein oder einer nahezu beliebigen Kontur folgen, die durch den Ätzvorgang präzise eingehalten wird. Somit ist es erstmals auch möglich, eine nahezu beliebige Schnittkontur zu erzeugen.

Obwohl es durch die längere Einwirkungsdauer im Bereich der den Außenseiten zugewandten Fehlstellen im Vergleich zu weiter innen in dem Werkstück liegenden Fehlstellen zu einer größeren Erweiterung kommt, ist dennoch eine insgesamt geringe kegelförmige Aufweitung zu beobachten.

Die so erzeugte Kontur der Ausnehmung oder Durchbrechung ist nach dem Abschluss des Ätzvorganges durch eine Abfolge von Querschnittserweiterungen und Einschnürungen gekennzeichnet, wobei die Querschnittserweiterungen und Einschnürungen weder eine übereinstimmende Querschnittsfläche noch einen übereinstimmenden Abstand zu benachbarten Querschnittserweiterungen und Einschnürungen aufweisen müssen. Die Differenz der Durchmesser von Querschnittserweiterung und Einschnürungen kann je nach Anzahl und Dichte der aufzuätzenden Fehlstellen weniger als 1 µm oder weniger als 100 nm betragen, sodass die Ausnehmung oder Durchbrechung sogar als makroskopisch glatt erscheinen kann.

Die Modifikationen im Glas können durch einen Laserstrahl hervorgerufen werden, welcher mithilfe eines diffraktiv-optischen Elementes so geformt wird, dass er eine lineare Kette von Modifikationen erzeugt. Die Modifikationen können durch eine Folge von Pulsen oder durch einen Einzelpuls erzeugt werden.

Aufgrund der Ausprägung des Verfahrens weisen erzeugte Ausnehmungen oder Durchbrechungen eine charakteristische Form auf. Da das grundsätzlich isotrop wirkende Ätzverfahren besonders stark an den modifizierten Bereichen im Werkstück angreift und der modifizierte Bereich typischerweise in Form einer linearen Kette von Modifikationen vorliegt, entstehen an den Mantelflächen der Ausnehmung oder Durchbrechung eine Mehrzahl von umlaufenden, konzentrischen Strukturen.

Aufgrund der Struktur der Durchbrechungen ist das Verfahren besonders gut für die Herstellung von Interposern geeignet, da die konzentrisch umlaufenden Mikrostrukturen, die in Folge des sukzessiven Aufätzens der Fehlstellen entstehen, für eine besonders gute Haftfestigkeit der späteren Metallschicht im Loch sorgen.

Besonders praxisrelevant ist der Einsatz derartiger Werkstücke als sogenannte Interposer zur elektrischen Verbindung der Anschlüsse mehrerer homogener oder heterogener Mikrochips. Ein Mikrochip als Prozessorkern hat typischerweise auf seiner Unterseite auf relativ kleiner Fläche verteilt mehrere Hundert Kontaktpunkte in engem Abstand zueinander. Wegen dieses engen Abstandes können diese Kontaktpunkte nicht direkt auf eine Schaltungsplatte, das sogenannte Motherboard, aufgebracht werden. Es wird deshalb ein Interposer als Verbindungselement eingesetzt, mit welchem die Kontaktierungsbasis verbreitert werden kann.

Ein derartiger Interposer besteht vorzugsweise aus Glas oder Silizium und enthält beispielsweise Kontaktflächen, Umverdrahtungen, Durchkontaktierungen sowie aktive und nicht aktive Komponenten.

Es ist bereits erkannt worden, dass erfindungsgemäß der Abstand der derart einzubringenden Ausnehmungen weiter reduziert werden kann, weil es durch die Laserstrahlung nicht zu einer Zerstörung des Werkstückes, sondern lediglich zu einer Modifikation oder Umwandlung kommt, wobei zugleich auch die Laserleistung vermindert werden kann. Besonders bevorzugt wird der Laser mit einer Wellenlänge betrieben, für die das Glaswerkstück transparent ist, sodass eine Durchdringung des Glaswerkstückes sichergestellt ist. Insbesondere wird dadurch eine im Wesentlichen zylindrische Modifikationszone koaxial zu der Laserstrahlachse herum sichergestellt, die zu einem konstanten Durchmesser der Durchbrechung oder der Ausnehmung führt.

Besonders vorteilhaft für die Siliziumbearbeitung ist eine Wellenlänge größer als 1,1 µm.

Besonders vorteilhaft bei der Erzeugung von Ausnehmungen oder Durchbrechungen in dem Werkstück, insbesondere aus Silizium, ist eine Ausrichtung der Ausbreitungsrichtung des Laserstrahls in einem Winkel der Strahlachse von ungefähr 0°, 45° oder 90° zur Kristallsymmetrie.

Die Pulsdauer kann gegenüber dem aus dem Stand der Technik bekannten Verfahren wesentlich reduziert werden. Bei einer besonders vorteilhaften Ausgestaltung des erfindungsgemäßen Verfahrens kann der Laser mit einer Pulsdauer von weniger als 100 Nanosekunden bis unter 1 Pikosekunden betrieben werden.

Bei geeigneter Wahl von Pulsenergie und Pulsdauer, vor allem bei der bevorzugten Verwendung von Pulsfolgen mit einer Wiederholrate im Megahertz-Bereich und Pulsdauern kleiner als 10 Pikosekunden, entstehen Filamente aufgrund von gegenläufigen Effekten, nämlich der Selbstfokussierung aufgrund des Kerr-Effektes und der Defokussierung durch Beugung aufgrund des kleinen Strahldurchmessers.

Grundsätzlich ist das Verfahren nicht auf bestimmte Materialien des Werkstückes beschränkt. Erfolg versprechend ist, wenn ein dielektrisches Material wie Glas verwendet wird. Besonders Erfolg versprechend ist es, wenn Glas mit einem wesentlichen Materialanteil an Aluminosilikat, insbesondere ein Boro-Aluminosilikat, eingesetzt wird.

Vorzugsweise wird das Werkstück zumindest in seinen modifizierten Bereichen beispielsweise durch ein Ätzverfahren, wie beispielsweise durch Flüssigätzen, Trockenätzen oder Dampfphasenätzen, oder durch Verdampfen mittels Hochspannung oder Hochfrequenz einem anisotropen Materialabtrag unterzogen, um so Ausnehmungen oder Durchbrechungen in das Werkstück einzubringen . Durch den anisotropen Materialabtrag ist für den eigentlichen Materialabtrag kein sequentielles, sondern ein flächig einwirkendes Abtragsverfahren nutzbar, welches lediglich geringe Anforderungen an den Prozess stellt. Vielmehr lässt sich über die Einwirkungsdauer der Materialabtrag quantitativ und qualitativ für alle in der beschriebenen Weise vorbehandelten und dementsprechend modifizierten Bereiche zugleich durchführen, sodass der Zeitaufwand für die Erzeugung der Vielzahl der Ausnehmungen oder Durchbrechungen in der Summe wesentlich reduziert ist.

Durch ein Gleichgewicht beider Effekte kann der Laserstrahl durch das für die Wellenlänge transparente Werkstück propagieren, wobei sein Durchmesser zumindest im Wesentlichen konstant bleibt.

Dabei können bei hohen Spitzenintensitäten im Laserstrahl in vorteilhafter Weise auch weitere Effekte, wie Plasmabildung, zur stärkeren Defokussierung genutzt werden.

In der Praxis verläuft das Wechselspiel zwischen Defokussierung und Selbstfokussierung periodisch, sodass eine Kette von modifizierten Materialbereichen entsteht. Je nach Ausprägung der Effekte kann auch ein zusammenhängender Kanal, ein sogenannter Plasmakanal entstehen.

Grundsätzlich kann die Ausbildung des Filamentes auf einen Teilabschnitt der maximalen Materialstärke des Materials beschränkt bleiben. Die Ausbildung des Filamentes endet, wenn der Strahl das Kerr-Medium verlässt und divergiert oder wenn die Intensität des Strahles so weit abgenommen hat, dass die defokussierende Beugung die Selbstfokussierung überwiegt.

Als Interposer wird in der Praxis beispielsweise eine mit Glasfaser verstärkte Epoxydharzplatte eingesetzt, die mit einer Anzahl von Löchern versehen ist. Auf der Oberfläche der Glasfasermatte laufen Leiterbahnen, die in die jeweiligen Löcher hineinführen, um diese zu verfüllen, und auf der anderen Seite der Glasfasermatte bis zu den Anschlusskontakten des Prozessorkernes führen. Bei Auftreten von Erwärmung kommt es allerdings zu unterschiedlichen Ausdehnungen zwischen dem Kernprozessor und der Glasfasermatte und damit zu mechanischen Spannungen zwischen diesen beiden Komponenten.

Die Filamente könnten durch eine Laserbearbeitung eingebracht werden, bei der eine Positionierung des Bearbeitungskopfes und die Bestrahlung abwechselnd durchgeführt werden. Vorzugsweise wird hingegen, während die Strahlung auf das Werkstück gelenkt wird, eine stetige Relativbewegung zwischen dem Bearbeitungskopf und dem Werkstück vorgenommen, sodass also der Laserstrahl kontinuierlich in einer "fliegenden" Bewegung über das Werkstück geführt wird, sodass also eine ununterbrochene Änderung der Relativposition eine extrem schnelle Bearbeitungsdauer ergibt.

Dabei kann die relative Position des Materials in Bezug auf den Bearbeitungskopf mit konstanter Geschwindigkeit verändert werden, sodass bei einer konstanten Pulsfrequenz der Abstand der zu erzeugenden Modifikationen einem vorbestimmten Rastermaß folgt.

Besonders bevorzugt wird die Strahlungsquelle mit einer Wellenlänge betrieben, für die das Werkstück transparent ist, sodass eine Durchdringung des Werkstückes sichergestellt ist. Insbesondere wird dadurch eine im Wesentlichen zylindrische Modifikationszone koaxial zu der Strahlachse herum sichergestellt, die zu einem konstanten Durchmesser der Durchbrechung oder der Ausnehmung führt.

Darüber hinaus kann es auch von Vorteil sein, wenn durch die Strahlungsquelle zusätzlich auch ein Oberflächenbereich abgetragen wird, um die Einwirkungszone des anisotropen Abtrages derart auszugestalten, dass ein kegelförmiger Einlassbereich der Filamente entsteht. Auf diese Weise kann die spätere Durchkontaktierung vereinfacht werden. Zudem wird in diesem Bereich beispielsweise die Einwirkung eines Ätzmittels konzentriert.

Bei einer Ausgestaltung des erfindungsgemäßen Verfahrens kann die Strahlungsquelle mit einer Pulsdauer von weniger als 50 ps, vorzugsweise weniger als 10 ps betrieben werden.

Bei einer anderen, ebenfalls besonders Erfolg versprechenden Ausgestaltung der Erfindung wird das Werkstück insbesondere nach der Modifikation mit einer flächigen, zumindest einzelnen, insbesondere eine Vielzahl von nachfolgend einzubringenden Durchbrechungen abdeckenden Metallschicht versehen. In einem folgenden Schritt werden die modifizierten Bereiche so abgetragen, dass eine von der Metallschicht einseitig verschlossene Ausnehmung erzeugt wird. Dabei wird die Metallschicht vorzugsweise nach der Modifikation, jedoch vor dem Materialabtrag aufgebracht, sodass nach dem Materialabtrag die beispielsweise als Leiterbahn aufgebrachte Metallschicht die Ausnehmung verschließt und dadurch zugleich eine optimale Basis für eine daran anzubringende Kontaktierung bildet. Die Durchkontaktierung erfolgt dabei im Bereich der Ausnehmung mit an sich bekannten Verfahren. Indem die Metallschicht als Leiterbahn aufgebracht wird, kann zudem in einfacher Weise ein gewünschtes Schaltbild erzeugt werden.

Bei einer anderen, ebenfalls besonders Erfolg versprechenden Ausgestaltung des Verfahrens wird das Werkstück vor einer Laserbehandlung mit einem Ätzresist auf zumindest einer Oberfläche flächig beschichtet. Durch Einwirkung des Laserstrahles als bevorzugte elektromagnetische Strahlungsquelle wird zugleich in einer punktförmigen Einwirkungszone das Ätzresist auf zumindest einer Oberfläche abgetragen und die Modifikation in dem Werkstück erzeugt. Auf diese Weise werden die nicht modifizierten Bereiche vor einer unerwünschten Einwirkung im nachfolgenden Ätzprozess geschützt und die Oberfläche des Materials daher nicht beeinträchtigt. Dabei behindert das Ätzresist nicht die Modifikation des darunter liegenden Materials. Vielmehr ist das Ätzresist für die Laserstrahlung entweder durchlässig oder wird nahezu punktförmig durch die Laserstrahlung abgetragen, beispielsweise also verdampft. Weiterhin ist nicht ausgeschlossen, dass das Ätzresist solche Substanzen enthält, die für die Modifikation unterstützend wirken, beispielsweise also den Modifikationsvorgang beschleunigen.

Selbstverständlich kann vor dem Auftrag des Ätzresists auf eine der Außenflächen des Materials die vorstehend beschriebene Metallschicht aufgebracht werden, um diese nach dem Entfernen des Ätzresists als Basis für die gewünschte Durchkontaktierung zu verwenden.

Das Ätzresist könnte nach dem Abschluss der Behandlung auf der Oberfläche des Materials verbleiben. Vorzugsweise wird jedoch das Ätzresist in an sich bekannter Weise nach dem anisotropen Materialabtrag von der Oberfläche des Materials entfernt.

Grundsätzlich ist das Verfahren nicht auf bestimmte Materialzusammensetzungen des Materials beschränkt. Besonders Erfolg versprechend ist es allerdings, wenn das Werkstück als einen wesentlichen Materialanteil ein Aluminosilikat, insbesondere ein Boro-Aluminosilikat aufweist.

Bei einer anderen, ebenfalls besonders praxisgerechten Ausgestaltung der Erfindung wird der Abstand benachbart in dem Werkstück erzeugter Filamente entlang einer Trennlinie derart realisiert, dass die modifizierten Bereiche unmittelbar aneinandergrenzen oder einen sehr geringen Abstand zueinander aufweisen, um auf diese Weise definierte Materialbereiche abzutrennen.

Die Trennung erfolgt nach dem Einbringen der Filamente entlang der Trennlinie infolge von inneren Spannungen des Materials oder aufgrund einer äußeren Krafteinwirkung. Alternativ oder ergänzend können die inneren Spannungen auch durch thermische Spannungen, insbesondere durch eine starke Temperaturdifferenz hervorgerufen werden.

Die Erfindung lässt verschiedene Ausführungsformen zu. Zur weiteren Verdeutlichung ihres Grundprinzips ist eine davon in der Zeichnung dargestellt und wird nachfolgend beschrieben. Diese zeigt jeweils in einer Prinzipdarstellung in
- Fig. 1: einen Verfahrensablauf beim Einbringen von Ausnehmungen in ein Werkstück;
- Fig. 2: mögliche Ausprägungen verschiedener Ausnehmungen;
- Fig. 3: weitere mögliche Ausprägungen verschiedener Ausnehmungen.

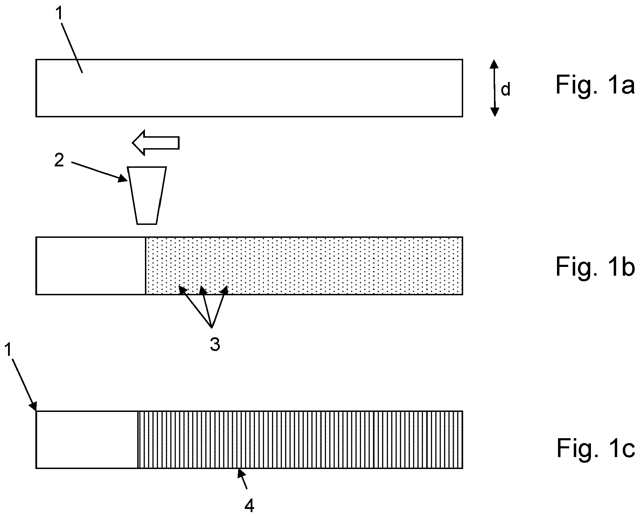

Figur 1 zeigt ein Ablaufdiagramm mit mehreren Verfahrensschritten zum Einbringen einer Durchbrechung in ein plattenförmiges Werkstück durch Bestrahlung mit Laserstrahlung und anschließendem Ätzen mit einzelnen Verfahrensschritten beim Einbringen einer Durchbrechung in ein plattenförmiges Werkstück 1. Hierzu wird in Figur 1a eine Laserstrahlung 2 auf die Oberfläche des Werkstückes 1 gerichtet. Die Dicke d des Werkstückes 1 beträgt dabei bis zu 3 mm. Die Einwirkungsdauer der Laserstrahlung 2 wird äußerst kurz gewählt, sodass lediglich eine Modifikation des Werkstückes 1 konzentrisch um eine Strahlachse des Laserstrahles eintritt. Hierzu wird der Laser mit einer Wellenlänge betrieben, für die das Werkstück 1 transparent ist. Ein derart modifizierter Bereich mit Fehlstellen 3 ist in Figur 1b in Form einer linearen Kette von Bläschen dargestellt. In einem nachfolgenden, in Figur 1c dargestellten Verfahrensschritt kommt es aufgrund der Einwirkung eines nicht dargestellten ätzenden Mediums zu einem anisotropen Materialabtrag in denjenigen, durch die Fehlstellen 3 gebildeten Bereichen des Werkstückes 1, die zuvor eine Modifikation durch die Laserstrahlung 2 erfahren haben. Entlang der zylindrischen Einwirkungszone entsteht dadurch eine Ausnehmung 4 als Durchbrechung in dem Werkstück 1.

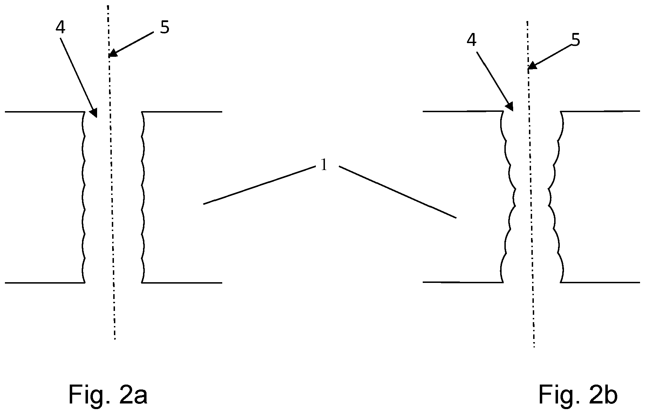

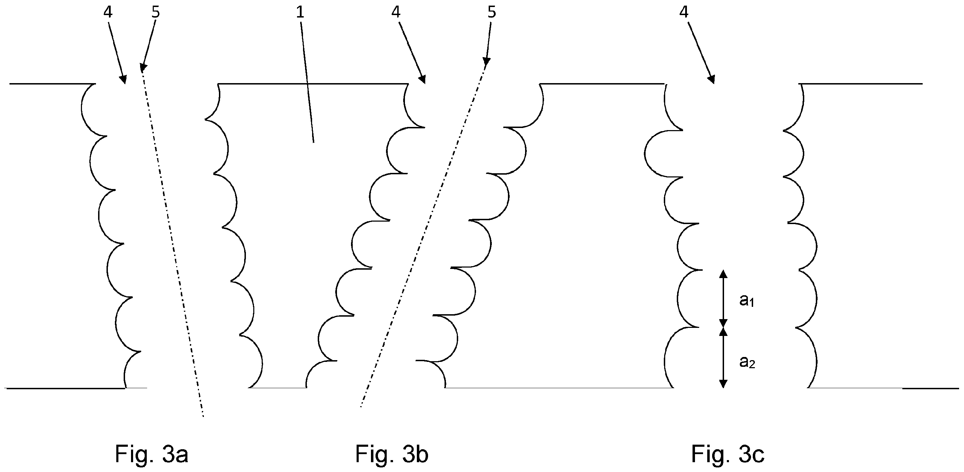

Die Durchbrechung weist eine Mehrzahl umlaufender, konzentrischer Strukturen auf der Mantelfläche auf, wie in den Darstellungen der Figuren 2a und 2b sowie Figur 3a bis 3c zu erkennen ist.

Die Ausnehmung 4 wird dabei infolge eines sukzessiven Aufätzens von einer Mehrzahl von aneinander gereihten Fehlstellen 3 gebildet, indem durch den Ätzvorgang sukzessive die zuvor erzeugten Fehlstellen 3, die durch die Ätzwirkung zu einem Hohlraum in dem Werkstück 1 erweitert werden, verbunden werden. Hierdurch gelangt die Ätzflüssigkeit schnell von Fehlstelle 3 zu Fehlstelle 3. Weil dabei der Einfluss der Schwerkraft nicht entscheidend ist erfolgt der Ätzfortschritt sowohl von oben als auch von unten und beginnt zugleich an beiden Außenseiten. Durch die im Verhältnis längere Einwirkungsdauer des ätzenden Mediums im Bereich der Außenseiten kommt es

zu einer konischen Erweiterung der Fehlstellen 3 im Bereich der äußeren Oberflächen wie in der Figur 2b zu erkennen.

Durch die Fehlstellen 3, die als Modifikationen innerhalb des Werkstückes 1 erzeugt werden, folgt der Ätzvorgang einer Linie 5, auf der die Fehlstellen 3 angeordnet sind. Die Linie 5 kann eine Gerade sein oder einer nahezu beliebigen Kontur folgen, die durch den Ätzvorgang präzise eingehalten wird. Somit ist es erstmals auch möglich, eine nahezu beliebige Schnittkontur zu erzeugen.

Obwohl es durch die längere Einwirkungsdauer im Bereich der den Außenseiten zugewandten Fehlstellen 3 im Vergleich zu weiter innen in dem Werkstück liegenden Fehlstellen 3 zu einer größeren Erweiterung kommt, ist dennoch eine insgesamt geringe kegelförmige Aufweitung zu beobachten.

Die so erzeugte Kontur der Ausnehmung 4 oder Durchbrechung ist nach dem Abschluss des Ätzvorganges durch eine Abfolge von Querschnittserweiterungen und Einschnürungen gekennzeichnet, deren Gestalt an einen Regenwurm erinnert, wobei die Querschnittserweiterungen und Einschnürungen weder eine übereinstimmende Querschnittsfläche, wie beispielsweise in den Figuren 2b und 3c zu erkennen, noch einen übereinstimmenden Abstand a1, a2, zu benachbarten Querschnittserweiterungen und Einschnürungen aufweisen müssen, wie dies in der Figur 3c gezeigt ist. Eine Querschnittserweiterung oder Einschnürung kann dabei in einer Querschnittsebene zur Hauptachse oder, wie in der Figur 3a gezeigt, geneigt hierzu angeordnet sein.

Benachbarte Querschnittserweiterungen oder Einschnürungen können weiterhin auch Mittelpunkte aufweisen, die auf einer gemeinsamen, gegenüber der Oberfläche des Werkstückes 1 geneigten Linie 5 liegen, sodass die Querschnittserweiterungen oder Einschnürungen versetzt zueinander angeordnet sind, wobei die Querschnittserweiterungen oder Einschnürungen wie in der Figur 3a gezeigt geneigt zu der Außenfläche oder wie in der Figur 3b gezeigt parallel zu der Außenfläche ausgerichtet werden können.

Wie in der Figur 3c zu erkennen können, die jeweiligen Flächenschwerpunkte benachbarter Querschnittserweiterungen einen Versatz aufweisen, sodass diese insbesondere nicht auf einer gemeinsamen Geraden angeordnet sind.

## Patentansprüche

1. Verfahren zum Einbringen mindestens einer Ausnehmung (4) und/oder einer Durchbrechung in ein plattenförmiges Werkstück (1) mit einer Dicke kleiner als 3 Millimeter, **wobei** die Ausnehmung (4) und/oder die Durchbrechung infolge eines sukzessive fortschreitenden Aufätzens einer Mehrzahl aufeinander folgender Fehlstellen (3) gebildet wird, wobei die erzeugte Kontur der Ausnehmung (4) oder Durchbrechung nach dem Abschluss des Ätzvorganges durch eine Abfolge von Querschnittserweiterungen und Einschnürungen gekennzeichnet ist, und wobei die Querschnittserweiterungen und Einschnürungen in einer Querschnittsebene zu einer Hauptachse der Ausnehmung (4) oder Durchbrechung oder geneigt hierzu und/oder abweichend von einer Flächennormalen zu der Oberfläche des Werkstückes (1) verlaufen.

2. Verfahren nach Anspruch 1, **dadurch gekennzeichnet, dass** die Querschnittserweiterungen und Einschnürungen keine mit den benachbarten Querschnittserweiterungen und Einschnürungen übereinstimmende Querschnittsfläche aufweisen.

3. Verfahren nach Anspruch 1 oder 2, **dadurch gekennzeichnet, dass** die Querschnittserweiterungen und Einschnürungen keinen mit den benachbarten Querschnittserweiterungen und Einschnürungen übereinstimmenden Abstand aufweisen.

4. Verfahren nach zumindest einem der vorhergehenden Ansprüche, **dadurch gekennzeichnet, dass** die Querschnittserweiterungen oder die Einschnürungen Mittelpunkte aufweisen, die nicht auf derselben Geraden liegen und/oder die Querschnittserweiterungen oder Einschnürungen versetzt zueinander angeordnet sind.

5. Verfahren nach zumindest einem der vorhergehenden Ansprüche, **dadurch gekennzeichnet, dass** die Höhen benachbarter Querschnittserweiterungen voneinander abweichen.

6. Verfahren nach zumindest einem der vorhergehenden Ansprüche, **dadurch gekennzeichnet, dass** die Fehlstellen (3) zumindest abschnittsweise abweichend von einer Geraden (Linie 5) eingebracht werden.

7. Verfahren nach zumindest einem der vorhergehenden Ansprüche, **dadurch gekennzeichnet, dass** sich die Fehlstellen (3) nicht berühren.

8. Verfahren nach zumindest einem der vorhergehenden Ansprüche, **dadurch gekennzeichnet, dass** sich die Fehlstellen (3) entlang einer Achse (Linie 5) von einer Oberfläche bis zu einer zweiten Oberfläche erstrecken.

9. Verfahren nach zumindest einem der vorhergehenden Ansprüche, **dadurch gekennzeichnet, dass** die Fehlstellen (3) durch die Wechselwirkung mit einer Laserstrahlung (2) entstehen.

10. Verfahren nach zumindest einem der vorhergehenden Ansprüche, **dadurch gekennzeichnet, dass** die Laserstrahlung (2) eine Wellenlänge hat, bei der das Material des Werkstückes (1) überwiegend transparent ist.

11. Verfahren nach zumindest einem der vorhergehenden Ansprüche, **dadurch gekennzeichnet, dass** die Laserstrahlung (2) in Form eines Pulses mit dem Werkstückmaterial wechselwirkt.

12. Verfahren nach zumindest einem der vorhergehenden Ansprüche, **dadurch gekennzeichnet, dass** die Laserstrahlung (2) in Form einer Pulsfolge mit dem Werkstückmaterial wechselwirkt und die Pulsfolge nicht mehr als 20 Einzelpulse umfasst.

13. Verfahren nach zumindest einem der vorhergehenden Ansprüche, **dadurch gekennzeichnet, dass** der Fokus der Laserstrahlung (2) durch eine zeitliche Verschiebung entlang der Strahlachse durch das Werkstück (1) wandert.

14. Verfahren nach zumindest einem der vorhergehenden Ansprüche, **dadurch gekennzeichnet, dass** der Fokus der Laserstrahlung (2) durch eine räumliche Strahlformung über die gesamte Dicke des Werkstückmaterials entlang der Strahlachse wechselwirkt.

15. Verfahren nach zumindest einem der vorhergehenden Ansprüche, **dadurch gekennzeichnet, dass** der Unterschied zwischen den Lagen der Fokuspunkte der paraxialen Strahlen und der Randstrahlen des Laserstrahles entlang der Strahlachse >100 µm, besonders bevorzugt >250 µm, ist.

16. Verfahren nach zumindest einem der vorhergehenden Ansprüche, **dadurch gekennzeichnet, dass** das Material des Werkstückes (1) als einen wesentlichen Materialanteil Glas, Silizium und/oder Saphir aufweist.
